# EUROPÄISCHE PATENTSCHRIFT

(11) **EP 1 849 184 B1**
(45) Veröffentlichungstag und Bekanntmachung des Hinweises auf die Patenterteilung: **11.07.2018**
(21) Anmeldenummer: 05823949.2
(22) Anmeldetag: 21.12.2005
(51) Int. Cl.: H01L 21/66

(54) **ERZEUGEN VON SiC-PACKS AUF WAFER-EBENE**
PRODUCING SiC PACKS ON A WAFER PLANE
PROCEDE POUR PRODUIRE DES ENSEMBLES EN SIC SUR UN PLAN DE PLAQUETTE

(30) Priorität: 14.02.2005 DE 102005006639
(43) Veröffentlichungstag der Anmeldung: 31.10.2007
(73) Patentinhaber: Siemens Aktiengesellschaft, 80333 München (DE)
(72) Erfinder: WEINKE, Robert, 81245 München (DE); WEIDNER, Karl, 81245 München (DE)
(86) Internationale Anmeldenummer: PCT/EP2005/057042
(87) Internationale Veröffentlichungsnummer: WO 2006/084524

(56) Entgegenhaltungen:
- WO-A-03/030247
- DE-A1- 3 503 433
- US-A- 5 446 310
- US-A- 5 817 533
- US-A- 5 843 799
- GUO-QUAN LU ET AL: "3-D, BOND-WIRELESS INTERCONNECTION OF POWER DEVICES IN MODULES WILL CUT RESISTANCE, PARASITICS AND NOISE" PCIM POWER ELECTRONIC SYSTEMS, INTERTEC INTERNATIONAL, VENTURA, CA, US, Bd. 26, Nr. 5, Mai 2000 (2000-05), Seiten 40,46-48,65, XP009053854 ISSN: 1523-4908

## Beschreibung

Die vorliegende Erfindung betrifft ein Verfahren gemäß dem Oberbegriff des Hauptanspruchs und eine Vorrichtung gemäß dem Oberbegriff des Nebenanspruchs.

SiC-Halbleiterbauelemente weisen lediglich eine begrenzte Stromaufnahmefähigkeit oder Stromtragfähigkeit auf. Bei SiC-Halbleiterbauelementen bzw. SiC-Chips ist nach dem Stand der Technik die Stromleitfähigkeit auf ca. 10A begrenzt.

Die DE 3503433 A1 offenbart ein Verfahren zur Herstellung einer elektrischen Matrix funktionsfähiger Schaltungen und Matrix-Anordnung aus funktionsfähigen elektrischen Schaltungen. Zur Wafer-Integration werden einzelne integrierte Schaltungen auf einem Wafer-Substrat verwendet und eine elektrisch geordnete Matrix funktionsfähiger, integrierter Schaltungen gebildet, die aus einer zuverlässigen Verteilung von funktionsfähigen, teilweise funktionsfähigen und nicht funktionsfähigen Schaltungen zugeordnet werden. Jede Schaltung wird einzeln auf Funktionsfähigkeit getestet, danach wird ein leitendes Gitter auf dem Wafer hergestellt, um sämtliche Schaltungen auf dem Wafer zu verbinden. Die als nicht funktionsfähig getesteten Schaltungen werden vor der Herstellung des Verbindungsgitters isoliert, indem man Sicherungen auftrennt, welche Verbindungen zwischen der defekten Schaltung und dem Leitungsgitter bilden. Jede Matrixzeile enthält redundante Decodier-Leitungen. Die redundanten Decodier-Leitungen werden programmiert, um funktionsfähige Schaltungen eines Ortes auf dem Halbleiter-Wafer-Substrat einem Matrixzeilenort in einer anderen Matrixzeile neu zuzuordnen, die defekte Schaltungen besitzt. Dadurch werden vollständige funktionsfähige Matrixzeilen gebildet. Zugehörige Eingabe- und Ausgabeleitungen werden in ähnlicher Weise einer richtigen Bit-Position innerhalb eines Eingabe- und Ausgabe-Bytes zugeordnet.

Die US 5,446,310 A offenbart eine Leistungsversorgungs-Vorrichtung mit einer integrierten Schaltung mit einer externen Sperrung von fehlerhaften Vorrichtungen und ein Verfahren zur Herstellung derselben. Eine Leistungsversorgungs-Vorrichtung mit integrierten Schaltungen weist eine Vielzahl von Zellblöcken auf, die elektrisch zueinander parallel geschaltet sind, wobei jeder der Zellblöcke zumindest eine Zelle, wie beispielsweise einen MOSFET, einschließt, die im Fall von mehreren Zellen elektrisch parallel geschaltet sind. Externe Messzugriffseinrichtungen, wie beispielsweise kleine Testflächen, werden an jeden Zellblock elektrisch angeschlossen, so dass die Zellblöcke von außen gemessen werden können und ein fehlerhafter Zellblock identifiziert werden kann. Von außen aktivierte Sperrungseinrichtungen, wie beispielsweise Schmelzverbindungen, sind ebenso bereitgestellt, so dass die Schmelzverbindungen, die an fehlerhafte Zellblöcke angeschlossen sind, geöffnet werden können. Eine betriebsbereite Leistungsversorgungs-Vorrichtung mit integrierter Schaltung wird auf diese Weise erhalten, abweichend von einem fehlerhaften Zellblock. Die Schmelzverbindungen sind nicht in der Lage, im Ansprechen auf den fehlerhaften Zellblock automatisch aktiviert zu werden, sind aber von außen geöffnet bei der Erfassung eines fehlerhaften Zellblocks. Mittels Abkopplung der Fehlermessung und der Zell-Sperrungsfunktionen können niedrige Pegel von Leckströmen für die Leistungsversorgungs-Vorrichtung spezifiziert werden. Die Schmelzverbindungen werden vorzugsweise unter Verwendung derselben Maske und desselben Materials wie das bei der Gate-Elektrode, ausgebildet, so dass weitere Herstellungsschritte nicht erforderlich sind.

Die US 5,843,799 A offenbart ein System und ein Verfahren zur Integration im Größenordnungsbereich eines Wafers, die für integrierte Schaltungen mit mittlerer Rohchipgröße mittels Zwischenverbindungen einer großen Anzahl von abgetrennten Speicher-Modulen auf einem Halbleiter-Wafer optimiert werden, um sowohl fehlerhafte Module als auch fehlerhafte Zwischenverbindungen/Leistungssegmente elektrisch auszuschließen und funktionsfähige Module und Zwischenverbindungs/ Leistungssegmente einzuschließen. Ein Satz von diskreten Verbindungen ist zu jedem der abgetrennten Module und Zwischenverbindungen / Leistungssegmenten zugeordnet und derartige Verbindungen werden erzeugt (oder unterbrochen), nachdem ein Modul oder eine Zwischenverbindung oder ein Leistungssegment getestet wurde. Ein Leistungsversorgungs-Netzwerk ist eingerichtet durch Kombination von arbeitenden Leistungssegmenten. Ein zweidirektionaler Bus ist eingerichtet zum Kombinieren von funktionsfähigen Zwischenverbindungssegmenten zum Anschließen an jedes der funktionsfähigen Module. Dieser bi-direktionale Bus besteht aus einer oder mehreren Hierarchien für Geschwindigkeit, Leistung und Ausbeutebetrachtungen. Jedem Modul ist ein Identitätscode unter Verwendung von diskreten Verbindungen zugeordnet.

Die US 5,817,533 offenbart Verfahren zur Herstellung großer Substratkapazitäten für Multi-Chip-Modulanwendungen und dergleichen unter Verwendung von Prozeduren, die mit allgemeinen Halbleiter-Herstellungsprozeduren kompatibel sind. Eine Kapazität ist ausgebildet, wobei deren obere Elektrode in eine Vielzahl von kleinen, segmentierten Flächen eingeteilt ist, die anfänglich voneinander elektrisch isoliert sind. Jede segmentierte kleine Fläche bildet eine Kapazität mit der darunter liegenden dielektrischen Schicht und einer unteren Kapazitätselektrode aus. Jede segmentierte Kapazität wird elektrisch getestet, wobei defekte Kapazitäten identifiziert werden. Eine leitende Schicht wird danach über den segmentierten, kleinen Flächen ausgebildet, derart, dass die leitende Schicht von den kleinen Flächen von defekten Kapazitäten elektrisch isoliert ist. Die leitende Schickt koppelt die intakten Kapazitäten elektrisch parallel zur Ausbildung einer Bypass-Kapazität, die einen hohen Wert aufweist, wobei die parasitären Induktivitäten klein sind. Große, eingebettete MCM-Bypass-Kapazitäten können auf diese Weise hergestellt werden mit minimalem Einfluss auf die gesamte Herstellungsausbeute.

Die WO 03/030247 A2 offenbart ein Verfahren zum Kontaktieren elektrischer Kontaktflächen auf einer Oberfläche eines Substrats. Es wird eine Folie aus Poliymid oder Epoxidbasis unter Vakuum auf die Oberfläche auflaminiert, so dass die Folie die Oberfläche mit den Kontaktflächen eng anliegend bedeckt und auf dieser Oberfläche haftet. Jede zu kontaktierende Kontaktfläche auf der Oberfläche wird durch Öffnen jeweiliger Fenster in der Folie freigelegt und jede freigelegte Kontaktfläche wird mit einer Schicht aus Metallfläche kontaktiert. Eine Anwendung ist die großflächige Kontaktierung von Leistungshalbleiterchips, die eine hohe Stromdichte erlaubt.

Es ist damit Aufgabe der vorliegenden Erfindung die begrenzte Stromtragfähigkeit von Halbleiterbauelementen, insbesondere von SiC-Halbleiterbauelementen, auf einfache und kostengünstige Weise wirksam zu erhöhen. Es soll eine hohe mechanische Stabilität der Halbleiterbauelemente geschaffen sein.

Die Aufgabe wird durch ein Verfahren gemäß dem Hauptanspruch und durch eine Vorrichtung gemäß dem Nebenanspruch gelöst. Weitere vorteilhafte Ausgestaltungen finden sich in den Unteransprüchen.

Durch gezieltes Parallelschalten von SiC-Chips auf Wafer-Ebene wird die Stromtragfähigkeit deutlich erhöht. Damit wird eine einfache und kostengünstige Herstellung von "SiC-Packs" (SiC-Halbleiterbauelementgruppen) mit höherer Stromtragfähigkeit ermöglicht.

Mindestens eine Halbleiterbauelmentegruppe, insbesondere einer SiC-Halbleiterbauelementegruppe, wird insbesondere mit den Schritten Erzeugen einer Mehrzahl von Halbleiterbauelementen auf einem Substrat, insbesondere auf einem Wafer, Testen der einzelnen Halbleiterbauelemente zur Erfassung funktionsfähiger Halbleiterbauelemente, Zusammenstellen mindestens einer aus einer Mehrzahl von funktionsfähigen Halbleiterbauelementen bestehenden Halbleiterbauelementegruppe, die eine zusammenhängende Flächenstruktur ausbildet, und elektrisches Parallelschalten der funktionsfähigen Halbleiterbauelemente der Halbleiterbauelementegruppe geschaffen. Die zusammenhängende Flächenstruktur liegt in einer Querschnittsebene durch das Substrat beziehungsweise den Wafer auf der Höhe der Halbleiterbauelementebene. Das heißt, die zusammenhängende Flächenstruktur kann bei einer horizontalen Schnittebene, durch die Halbleiterbauelemente hindurch, von oben erkannt werden. Das Erkennen ist ebenso bei einer Draufsicht von oben auf das Substrat bzw. den Wafer möglich. Mittels der zusammenhängenden Flächenstruktur ist ein einfaches elektrisches Parallelschalten der Halbleiterbauelemente ausführbar.

Gemäß einer vorteilhaften Ausgestaltung erfolgt das Zusammenstellen der Halbleiterbauelementegruppe derart, dass die zusammenhängende Flächenstruktur, nach deren Herauslösen vom Substrat, insbesondere vom Wafer, weiterhin mechanisch stabil bleibt. Das heißt, die Flächenstruktur wird entsprechend ausgewählt. Grundsätzlich kann Stabilität ebenso entlang der Höhe des Wafers erzeugt sein. Das heißt, in dem Fall, dass lediglich zwei Ecken von Halbleiterbauelementen aneinander angrenzen, kann die Flächenstruktur an dieser Stelle gegebenenfalls trotzdem stabil sein.

Gemäß einer vorteilhaften Ausgestaltung erfolgt das Zusammenstellen der Halbleiterbauelementegruppe derart, dass in der zusammenhängenden Flächenstruktur jeweils zwei funktionsfähige Halbleiterbauelemente entlang eines gemeinsamen Linienabschnitts aneinander angrenzen. Hier liegt der gemeinsame Linienabschnitt der zusammenhängenden Flächenstruktur ebenso in der horizontalen Querschnittsebene durch die Halbleiterbauelemente hindurch.

Gemäß einer vorteilhaften Ausgestaltung erfolgt das Zusammenstellen der Halbleiterbauelementegruppe derart, dass zur zusammenhängenden Flächenstruktur ausgewählte defekte Halbleiterbauelemente hinzugefügt werden.

Gemäß einer vorteilhaften Ausgestaltung erfolgt das Zusammenstellen der Halbleiterbauelementegruppe derart, dass in der zusammenhängenden Flächenstruktur die Anzahl defekter Halbleiterbauelemente minimal ist. Das heißt, in dem Fall, das defekte Halbleiterbauelemente zur Erzeugung von mechanischer Stabilität erforderlich sind, sollte deren Anzahl möglichst klein sein. Dadurch kann die zusammenhängende Flächenstruktur möglichst klein bereit gestellt sein.

Gemäß einer vorteilhaften Ausgestaltung erfolgt das Zusammenstellen der Halbleiterbauelementegruppe derart, dass die zusammenhängende Flächenstruktur rechtwinklig zueinander angeordnete Kanten aufweist. Damit ist ein Herauslösen, insbesondere ein Herausschneiden, der Halbleiterbauelementegruppe wirksam auf einfache Weise, insbesondere durch Sägen, ausführbar.

Gemäß einer vorteilhaften Ausgestaltung erfolgt das Zusammenstellen der Halbleiterbauelementegruppe derart, dass die zusammenhängende Flächenstruktur ein Rechteck, insbesondere ein Quadrat ist. Mit diesen Flächenstrukturen ist ein Herauslösen sehr wirksam vereinfacht.

Gemäß einer vorteilhaften Ausgestaltung erfolgt das Kontaktieren einer oder mehrerer elektrischer Kontaktflächen einer hergestellten Halbleiterbauelementegruppe, insbesondere auf einer Oberfläche eines Substrats, insbesondere mit den Schritten Aufbringen einer Schicht aus elektrisch isolierendem Material auf die Oberflächen der Halbleiterbauelementegruppe und gegebenenfalls des Substrats, Freilegen jeder zu kontaktierenden Kontaktfläche auf der Oberfläche der Halbleiterbauelementegruppe und gegebenenfalls des Substrats durch Öffnen jeweiliger Fenster in der Schicht aus elektrisch isolierendem Material, und flächiges Kontaktieren jeder freigelegten Kontaktfläche mit einer Schicht aus elektrisch leitendem Material. Die Halbleiterbauelementegruppe kann allein kontaktiert werden. Die Halbleiterbauelementegruppe kann auf einem Substrat und/oder auf einem Wafer angeordnet sein. Substrat beziehungsweise Wafer können ebenso Kontaktflächen aufweisen, die auf gleiche Weise entsprechend den Kontaktflächen der Halbleiterbauelementegruppe flächig kontaktiert werden.

Gemäß einer vorteilhaften Ausgestaltung erfolgt das Aufbringen der Schicht aus elektrisch isolierendem Material beispielsweise mittels Physical Vapor Deposition (PVD) und Plasma Ion Assisted Deposition (PIAD). Dies betrifft insbesondere die Bereitstellung einer Glasbeschichtung.

Gemäß einer weiteren vorteilhaften Ausgestaltung ist die Schicht aus elektrisch isolierendem Material flächig oder vorstrukturiert oder strukturiert aufgebracht. Beim strukturierten Aufbringen wird die Schicht während des Aufbringvorgangs strukturiert erzeugt. Es können beispielsweise Schablonen verwendet werden.

Gemäß einer weiteren vorteilhaften Ausgestaltung erfolgt nach dem flächigen Kontaktieren in und/oder auf der Schicht aus dem elektrisch leitenden Material ein Ausbilden mindestens einer Leiterbahn. Diese kann auf der Halbleiterbauelementegruppe und/oder dem Substrat und/oder dem Wafer verlaufen.

Gemäß einer vorteilhaften Ausgestaltung erfolgt das Herstellen einer Vorrichtung mit Halbleiterbauelementen, insbesondere SiC-Halbleiterbauelementen, wobei insbesondere mindestens eine aus einer Mehrzahl von funktionsfähigen Halbleiterbauelementen bestehende Halbleiterbauelementegruppe erzeugt ist, die eine zusammenhängende Flächenstruktur ausbildet, wobei die funktionsfähigen Halbleiterbauelemente der Halbleiterbauelementegruppe zueinander elektrisch parallel geschaltet sind. Die Halbleiterbauelementegruppe ist bevorzugt auf einem Substrat angeordnet.

Gemäß einer vorteilhaften Ausgestaltung erfolgt ein Kontaktieren zumindest einer Kontaktfläche auf wenigstens einer Halbleiterbauelementegruppe, wobei eine Schicht aus elektrisch isolierendem Material eng an der Halbleiterbauelementegruppe anliegt und bei der Kontaktfläche auf der Halbleiterbauelementegruppe ein Fenster aufweist, in welchem diese Kontaktfläche frei von der Folie und flächig mit einer Schicht aus elektrisch leitendem Material kontaktiert ist. Die Halbleiterbauelementegruppe kann allein oder auf einem Substrat und/oder einem Wafer angeordnet sein. Das Substrat beziehungsweise der Wafer können ebenso Kontaktflächen aufweisen, die auf vergleichbare Weise wie die Halbleiterbauelementegruppe flächig kontaktiert sind, und insbesondere gleich erzeugte Leiterbahnen aufweisen.

Gemäß einer vorteilhaften Ausgestaltung ist die Schicht aus elektrisch isolierendem Material eine Folie, ein Isolierlack und/oder eine Glasbeschichtung.

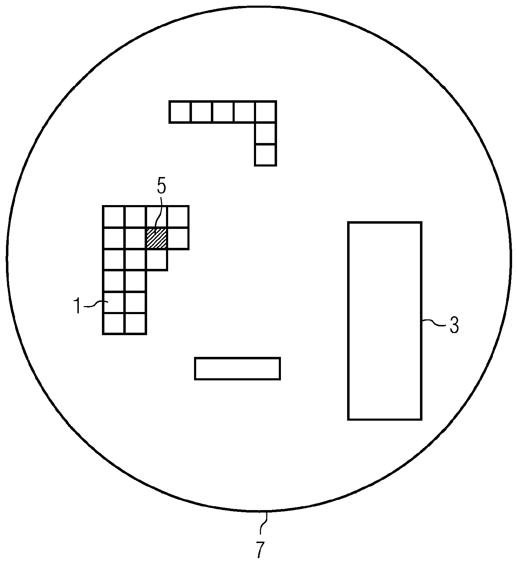

Die vorliegende Erfindung wird anhand eines Ausführungsbeispiels in Verbindung mit der Fig. 1 näher beschrieben. Es zeigt
- Fig. 1:: eine Draufsicht auf eine horizontale Schnitt ebene, durch Halbleiterbauelemente auf einem Wafer hindurch, und zwar vor dem Herauslösen der Halbleiterbauelementegruppen.

Fig. 1 zeigt eine Draufsicht auf eine horizontale Schnittebene, durch Halbleiterbauelemente 1 und 5 auf einem Wafer 7 hindurch, und zwar vor dem Herauslösen der Halbleiterbauelementegruppen 3. Bezugszeichen 1 bezeichnet funktionsfähige Halbleiterbauelemente und Bezugszeichen 5 bezeichnet defekte Halbleiterbauelemente. In Fig. 1 grenzen Halbleiterbauelemente 1 und 5 über gemeinsame Kanten aneinander an. Das defekte Halbleiterbauelement 5 in der linken Halbleiterbauelementegruppe 3 ist Bestandteil dieser Halbleiterbauelementegruppe 3 und erhöht deren mechanische Stabilität. Bevorzugte zusammenhängende Flächenstrukturen weisen die Form eines Rechtecks auf. Die Halbleiterbauelementegruppe 3 können auf einfache Weise aus dem Wafer 7 herausgesägt werden. Andere Verfahren zur Herauslösung, beispielsweise mittels Laser, sind ebenso verwendbar. Grundsätzlich sind alle Formen einer zusammenhängenden Flächenstruktur verwendbar. Grundsätzlich kann die Fläche beispielsweise ebenso die Form eines Ovals oder eines Kreises oder eines Dreiecks oder eines Vielecks aufweisen.

Die heraus gelösten Halbleiterbauelementegruppen 3 können auf einfache Weise nach der so genannten SiPLIT-(Siemens Planar Interconnect Technology) Technologie gemäß der WO 2003030247-A2 kontaktiert werden. Deren Inhalt gehört ausdrücklich zur Offenbarung vorliegender Anmeldung. Demnach erfolgt ein Kontaktieren zumindest einer Kontaktfläche auf wenigstens einer Halbleiterbauelementegruppe 3 auf der Oberfläche eines Substrats, wobei eine Folie eng an der Halbleiterbauelementegruppe 3 anliegt und bei der Kontaktfläche auf der Halbleiterbauelementegruppe 3 ein Fenster aufweist, in welchem diese Kontaktfläche frei von der Folie und flächig mit einer Schicht aus elektrisch leitendem Material kontaktiert ist. Gemäß einer vorteilhaften Ausgestaltung erfolgt nach dem flächigen Kontaktieren in und/oder auf der Schicht aus dem elektrisch leitenden Material ein Ausbilden mindestens einer Leiterbahn.

Gemäß einer vorteilhaften Ausgestaltung kann alternativ zu einer einseitigen Metallisierung eine zweiseitige Metallisierung beispielsweise aus Kupfer auf der Folie aufgebracht sein. Damit befindet sich Kupfer zusätzlich ebenso unter der Folie. Eine obere Metallschicht kann zusätzlich als hermetische Abdichtung bereit gestellt sein. Damit kann eine Schichtfolge Abdeckung, Cu-Folie, Isolierfolie und Substrat geschaffen sein. Eine Kupferankontaktierung kann mittels Löten, Kleben, insbesondere Aufkleben, erfolgen. Die hermetische Abdeckung über der metallisierten Folie kann derart bereitgestellt sein, dass ein Metallanschluss an Keramik vorgesehen ist. Alternativ oder kumulativ zu einem Multilayeraufbau kann eine beidseitige Kühlung erzeugt sein.

## Patentansprüche

1. Verfahren zur Herstellung mindestens einer Halbleiterbauelementegruppe (3), mit den Schritten
- Erzeugen einer Mehrzahl von Halbleiterbauelementen (1, 5) auf einem Substrat,
- Testen der einzelnen Halbleiterbauelemente (1, 5) zur Erfassung funktionsfähiger Halbleiterbauelemente (1),
- Zusammenstellen mindestens einer aus einer Mehrzahl von funktionsfähigen Halbleiterbauelementen (1) bestehenden Halbleiterbauelementegruppe (3), die eine zusammenhängende Flächenstruktur ausbildet,
- elektrisches Parallelschalten der funktionsfähigen Halbleiterbauelemente (1) der Halbleiterbauelementegruppe (3), **gekennzeichnet durch**
- Zusammenstellen der Halbleiterbauelementegruppe (3) derart, dass die zusammenhängende Flächenstruktur, nach deren Herauslösen vom Substrat, mechanisch stabil ist, dadurch dass zur zusammenhängenden Flächenstruktur ausgewählte defekte Halbleiterbauelemente (5) hinzugefügt werden.

2. Verfahren nach Anspruch 1,
**dadurch gekennzeichnet, dass**
die Anzahl der ausgewählten defekten Halbleiterbauelemente minimal ist.

3. Verfahren nach Anspruch 1 oder 2,
- dass in der zusammenhängenden Flächenstruktur jeweils zwei funktionsfähige Halbleiterbauelemente (1) entlang eines gemeinsamen Linienabschnitts aneinander angrenzen.

4. Verfahren nach Anspruch 1, 2 oder 3,
**dadurch gekennzeichnet, dass**
die Halbleiterbauelementegruppe (3) eine SiC-Halbleiterbauelementegruppe (3) ist.

5. Verfahren nach einem der Ansprüche 1 bis 4,
**dadurch gekennzeichnet, dass**
das Substrat ein Wafer (7) ist.

6. Verfahren nach einem oder mehreren der Ansprüche 1 bis 5, **gekennzeichnet durch**
- Zusammenstellen der Halbleiterbauelementegruppe (3) derart, dass die zusammenhängende Flächenstruktur rechtwinklig zueinander angeordnete Kanten aufweist.

7. Verfahren nach einem der Ansprüche 1 bis 6, **gekennzeichnet durch**
- Zusammenstellen der Halbleiterbauelementegruppe (3) derart, dass die zusammenhängende Flächenstruktur ein Rechteck, insbesondere ein Quadrat ist.

8. Verfahren zum Kontaktieren einer oder mehrerer elektrischer Kontaktflächen einer nach einem Verfahren nach einem oder mehreren der Ansprüche 1 bis 7 hergestellten Halbleiterbauelementegruppe (3), mit den Schritten:
- Aufbringen einer Schicht aus elektrisch isolierendem Material auf die Oberfläche der Halbleiterbauelementegruppe (3),
- Freilegen jeder zu kontaktierenden Kontaktfläche auf der Oberfläche der Halbleiterbauelementegruppe (3) durch Öffnen jeweiliger Fenster in der Schicht aus elektrisch isolierendem Material, und
- flächiges Kontaktieren jeder freigelegten Kontaktfläche mit einer Schicht aus elektrisch leitendem Material.

9. Verfahren nach Anspruch 8,
**dadurch gekennzeichnet, dass**
- das Aufbringen der Schicht aus elektrisch isolierendem Material mittels Physical Vapor Deposition (PVD) und/oder Plasma Ion Assisted Deposition (PIAD) erfolgt.

10. Verfahren nach Anspruch 8 oder 9,
**dadurch gekennzeichnet, dass**
- das Aufbringen der Schicht aus elektrisch isolierendem Material flächig oder vorstrukturiert oder strukturiert erfolgt.

11. Verfahren nach Anspruch 8, 9 oder 10, wobei nach dem flächigen Kontaktieren in und/oder auf der Schicht aus dem elektrisch leitenden Material mindestens eine Leiterbahn erzeugt wird.

## Claims

1. Method for producing at least one semiconductor component set (3), comprising the steps:
- producing a plurality of semiconductor components (1, 5) on a substrate,
- testing the individual semiconductor components (1, 5) to detect operational semiconductor components (1),
- assembling at least one semiconductor component set (3), which set consists of a plurality of operational semiconductor components (1) and which forms a coherent flat structure;
- electrically connecting the operative semiconductor components (1) of the semiconductor component set (3) in parallel,
**characterised by**
- assembling the semiconductor component set (3) in such a way that the coherent flat structure, after the release thereof from the substrate, is mechanically stable, in that selected defective semiconductor components (5) are added to the coherent flat structure.

2. Method according to claim 1,
**characterised in that**
the number of selected defective semiconductor components is minimal.

3. Method according to claim 1 or 2,
- that in the coherent flat structure, two operational semiconductor components (1) are in each case adjacent to each other along a common linear section.

4. Method according to claim 1, 2 or 3,
**characterised in that**
the semiconductor component set (3) is a SiC semiconductor component set (3).

5. Method according to one of claims 1 to 4,
**characterised in that**
the substrate is a wafer (7).

6. Method according to one or a plurality of claims 1 to 5,
**characterised by**
- assembling the semiconductor component set (3) in such a way that the coherent flat structure comprises edges that are disposed at right angles to each other.

7. Method according to one of claims 1 to 6,
**characterised by**
- assembling the semiconductor component set (3) in such a way that the coherent flat structure is a rectangle, in particular a square.

8. Method for creating contacts between one or a plurality of electrical contact surfaces of a semiconductor component set (3) produced according to a method according to one or a plurality of claims 1 to 7, comprising the following steps:
- application of a layer of electrically insulating material onto the surface of the semiconductor component set (3),
- uncovering of each contact surface with which contact is to be established on the surface of the semiconductor component set (3) by opening respective windows in the layer of electrically insulating material and
- making of contacts in a plane manner between each contact surface that has been uncovered and a layer of electrically insulating material.

9. Method according to claim 8,
**characterised in that**
- the application of the layer of electrically insulating material ensues by means of Physical Vapour Deposition (PVD) and/or Plasma Ion Assisted Deposition (PIAD).

10. Method according to claim 8 or 9,
**characterised in that**
- the application of the layer of electrically insulating material ensues in a plane manner or in a prestructured or structured manner.

11. Method according to claim 8, 9, or 10, wherein after making of contacts in a plane manner in and/or on the layer of the electrically insulating material, at least one strip conductor is created.

## Revendications

1. Procédé de production d'au moins un groupe (3) de composants à semi-conducteur, comprenant les stades
- on produit une pluralité de composants (1, 5) à semi-conducteur sur un substrat,
- on teste les divers composants (1, 5) à semi-conducteur pour détecter des composants (1) à semi-conducteur aptes à fonctionner,
- on regroupe au moins un groupe (3) de composants à semi-conducteur constitués d'une pluralité de composants (1) à semi-conducteur aptes à fonctionner, groupe qui forme une structure de surface ininterrompue,
- on monte en parallèle électriquement les composants à semi-conducteur aptes à fonctionner du groupe (3) de composants à semi-conducteur,
**caractérisé en ce que**
- on regroupe le groupe (3) de composants à semi-conducteur de manière à ce que la structure de surface ininterrompue soit, après retrait du substrat, stable mécaniquement, **en ce que** l'on ajoute des composants (5) à semi-conducteur défectueux sélectionnés à la structure de surface ininterrompue.

2. Procédé suivant la revendication 1,
**caractérisé en ce que**
le nombre des composants à semi-conducteur défectueux sélectionnés est minimum.

3. Procédé suivant la revendication 1 ou 2,
- en ce que, dans la structure de surface ininterrompue, respectivement deux composants (1) à semi-conducteur aptes à fonctionner sont voisins l'un de l'autre le long d'un segment de ligne commun.

4. Procédé suivant la revendication 1, 2 ou 3,
**caractérisé en ce que**
le groupe (3) de composants à semi-conducteur est un groupe (3) de composants à semi-conducteur SiC.

5. Procédé suivant l'une des revendications 1 à 4,
**caractérisé en ce que**
le substrat est une tranche (7).

6. Procédé suivant l'une ou plusieurs des revendications 1 à 5,
**caractérisé en ce que**
- on regroupe le groupe (3) de composants à semi-conducteur de manière à ce que la structure de surface ininterrompue ait des bords à angle droit l'un par rapport à l'autre.

7. Procédé suivant l'une des revendications 1 à 6,
**caractérisé en ce que**
- on regroupe le groupe (3) de composants à semi-conducteur de manière à ce que la structure de surface ininterrompue soit un rectangle, notamment un carré.

8. Procédé de mise en contact d'une ou de plusieurs surfaces de contact électrique d'un groupe (3) de composants à semi-conducteur produits par le procédé suivant l'une ou plusieurs des revendications 1 à 7, comprenant les stades :
- on dépose une couche de matériau isolant électriquement à la surface du groupe (3) de composants à semi-conducteur,
- on met à nu chaque surface de contact à contacter sur la surface du groupe (3) de composants à semi-conducteur en ouvrant des fenêtres respectives dans la couche en matériau isolant électriquement et
- on contacte en surface chaque surface de contact mise à nu avec une couche en un matériau conducteur de l'électricité.

9. Procédé suivant la revendication 8,
**caractérisé en ce que**
- on effectue le dépôt de la couche en matériau isolant électriquement au moyen d'une Physical Vapor Deposition (PVD) et/ou d'une Plasma Ion Assisted Deposition (PIAD).

10. Procédé suivant la revendication 8 ou 9,
**caractérisé en ce que**
- on effectue le dépôt de la couche en matériau isolant électriquement en surface ou d'une manière préstructurée ou structurée.

11. Procédé suivant la revendication 8, 9 ou 10, dans lequel, après la mise en contact en surface, on produit une piste conductrice dans et/ou sur la couche en le matériau conducteur de l'électricité.
